# EUROPEAN PATENT SPECIFICATION

(11) **EP 4 521 509 B1**
(45) Date of publication and mention of the grant of the patent: **04.02.2026**
(21) Application number: 23306484.9
(22) Date of filing: 07.09.2023
(51) Int. Cl.: H01M 10/42, G01R 31/392, H01M 10/48, H01M 10/0525

(54) **MONITORING METHOD FOR A LI-ION BATTERY PACK, MODULE, OR CELL, AND ASSOCIATED BATTERY PACK**
ÜBERWACHUNGSVERFAHREN FÜR EIN LI-IONEN-BATTERIEPACK, MODUL ODER ZELLE UND ZUGEHÖRIGES BATTERIEPACK
PROCÉDÉ DE SURVEILLANCE D'UN BLOC-BATTERIE AU LITHIUM-ION, MODULE OU CELLULE, ET BLOC-BATTERIE ASSOCIÉ

(43) Date of publication of application: 12.03.2025
(73) Proprietor: Automotive Cells Company SE, 33520 Bruges (FR); SAFT, 92300 Levallois-Perret (FR)
(72) Inventor: ULLDEMOLINS, Michel, 33300 BORDEAUX (FR); CHERNOV, Sergey, 33110 LE BOUSCAT (FR)
(74) Representative: Lavoix

(56) References cited:
- US-A1- 2017 203 667
- US-A1- 2022 276 314
- US-A1- 2022 278 378

## Description

The present invention concerns a method for monitoring a Li-ion battery pack comprising a plurality of battery cells, a Li-ion battery module comprising a plurality of battery cells, or a Li-ion battery cell, the or each cell comprising a negative active material.

Prior art document US2022/276314 discloses a battery management apparatus and a method diagnosing a state of a battery cell in real time.

The invention further relates to an associated battery pack.

Battery cells are susceptible to ageing, in particular in an unsustainable way relative to the use of the battery.

Such ageing may lead, on short term, to consequences such as a loss of capacity of the battery or thermal runaway.

In particular, lithium plating corresponds to the formation of metallic lithium on top of the negative electrode. It is a serious degradation mechanism, since it can lead to a rapid loss of capacity of the cell, and/or to a trigger mechanism for a thermal runaway of the cell, and even the entire pack.

Risk of lithium deposition occurs when the rate at which the negative active material is lost is higher than the rate of active lithium loss.

However, loss of negative active material at delithiated state is a hidden degradation mechanism, as long as the remaining negative material is able to accommodate for the remaining active lithium.

The aim of the invention is thus to propose a method for monitoring a battery pack comprising a plurality of battery cells, a battery module comprising a plurality of battery cells, or a battery cell, where ageing is detected early, in particular before lithium deposition occurred and therefore before any incidents.

To that end, the invention relates to a method for monitoring a Li-ion battery pack comprising a plurality of battery cells, a Li-ion battery module comprising a plurality of battery cells, or a Li-ion battery cell, the or each cell comprising negative active material, the negative active material comprising a silicon-based material, the method comprising the following phases:
- charging the battery pack or module or cell,
- using the battery pack or module or cell, said using leading to a discharge of the battery pack or module or cell,
the method comprising the following steps:
- measuring the voltage of the or each cell and/or of the pack and/or of the module during the discharge,
- generating an electrochemical profile during the discharge, the electrochemical profile representing the voltage depending on the capacity, said electrochemical profile being calculated from the measured voltage(s),
- determining from the electrochemical profile the contribution of the silicon-based material to said electrochemical profile, and
- detecting an early indicator of imminent lithium plating based on the contribution of the silicon-based material to said electrochemical profile.

By monitoring the contribution of the silicon-based material to the electrochemical profile, this allows the detection of early indicators of imminent lithium plating, and thus of ageing.

In the case of a negative active material comprising a silicon-based material, Li₁₅Si₄, the most lithiated phase of the LiₓSi alloy accessible electrochemically at room temperature, is formed when the silicon-based material is close to reach full capacity, in particular for a state of charge of at least 97%.

However, the negative electrode has a higher surface capacity than the positive electrode, for example of a difference comprised between 10% and 20%. Thus, in normal operating condition and cell health, the negative electrode state of charge never exceeds 91%, which excludes the possibility to crystallize Li₁₅Si₄ in the cell. Consequently, if Li₁₅Si₄ is crystallized on the negative electrode, the cell is not in a healthy state.

The delithiation of the crystallized Li₁₅Si₄ is visible on the electrochemical profile of the silicon-based material during the discharge of the cell. Said delithiation is, for example, visible via a plateau at 440 mV vs Li⁺/Li. Here the voltage at which said plateau appears further depends on other cell parameters. The longer the plateau is, the higher the amount of Li₁₅Si₄ is being delithiated, and thus has been formed previously, the less healthy the cell is.

Thus, the method allows early detecting of the ageing of a cell through loss of negative active material at the delithiated state, by monitoring the electrochemical profile of the silicon-based material for any abnormality. Said abnormality corresponds to an indication of the delithiation of the crystallized Li₁₅Si₄.

According to specific embodiments of the invention, the method also has one or more of the following features, considered alone or according to any technically possible combination(s):
- the detecting comprises comparing the contribution of the silicon-based material to the electrochemical profile to a predetermined or predefined profile;
- if the value of the contribution of the silicon-based material to the calculated electrochemical profile differs from a voltage value of the predetermined or predefined profile for the same capacity of at least a deviation value, the early indicator of imminent lithium plating is detected;

- the deviation value is between 5 mV and 30 mV, more precisely between 15 mV and 25 mV;
- if the early indicator of imminent lithium plating is detected, the method further comprises at least one of the following steps: displaying a visual alert, generating an audible alarm, reducing the state of charge of the battery pack or module or cell, and reducing a charging current of the battery pack or module or cell;
- the voltage(s) is measured according to an acquisition frequency, the generating, the determining and the detecting being implemented at an analysis frequency, the acquisition frequency being between the analysis frequency and ten times the analysis frequency;
- at the end of the charging step, the battery pack or module or cell has a state of charge superior or equal to 95%;
- for monitoring a battery pack, wherein the battery cells are connected in series, the voltage of each cell and of the pack being measured, the electrochemical profile of the silicon-based material being generated for each cell, such that the detecting of the early indicator of imminent lithium plating is done for each cell independently;
- the negative active material of each or the cell comprises at least 1,5 % mass of silicon;
- the silicon-based material comprises pure silicon nanodomains, said pure silicon nanodomains being bigger than 10 nm;
- the measuring, the determining, the generating and the detecting steps are implemented by a battery management system.

The invention further relates to a battery pack comprising a plurality of battery cells and a battery management system, each cell comprising negative active material, the negative active material comprising a silicon-based material, the battery management system comprises, a reception module, a profile module and a detection module, the reception module being designed to receive a measured voltage of the or each cell and/or of the module and/or of the pack, the profile module being adapted to generate an electrochemical profile of the silicon-based material during a discharge of the battery pack, the electrochemical profile representing the voltage linked to the silicon-based material depending on the capacity, said electrochemical profile being calculated from the measured voltage(s) received by the reception module, the detection module being designed to receive the electrochemical profile from the profile module and to detect an early indicator of imminent lithium plating based on said electrochemical profile.

Other features and advantages of the invention will appear upon reading the following description, provided solely as an example and done in reference to the appended drawings, in which:
- Figure 1 is a schematic view of an example of a Li-ion battery pack according to the invention,
- Figure 2 is a schematic view of an example of a battery cell of the battery pack,
- Figure 3 is a schematic representation of steps of a method according to a first embodiment of the invention, and
- Figure 4 is a schematic representation of steps of a method according to a second embodiment of the invention.

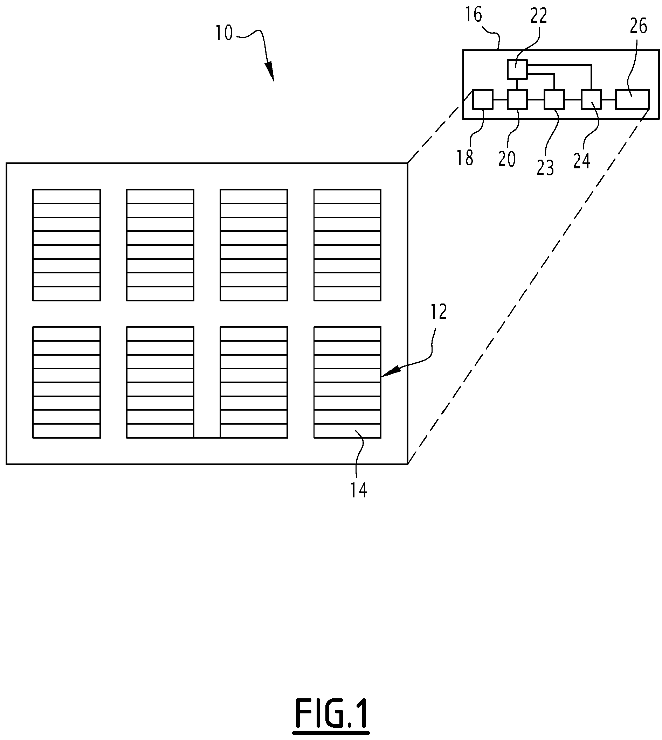

A Li-ion battery pack, more particularly for a vehicle, 10 is represented on figure 1.

The battery pack 10 comprises a plurality of battery cells 14.

More particularly, the battery pack 10 comprises a plurality of battery modules 12, each module 12 comprises a plurality of battery cells 14.

The battery pack 10 is equipped with sensors for measuring the voltages of each cell and/or of the pack and/or of each module. More particularly, the battery pack 10 is equipped with sensors for measuring the voltages of each cell and of the pack.

The battery pack further comprises a battery management system 16.

The battery management system 16 is adapted to implement the method of the invention, and will be further described in parallel to the description of the method of the invention.

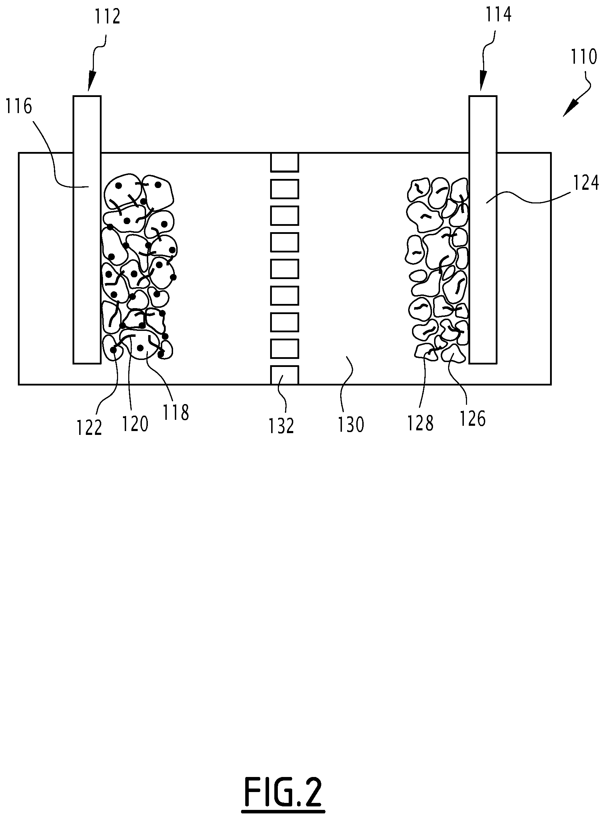

An example of a battery cell 110 is represented on figure 2.

The battery cell 110 conventionally comprises a positive electrode 112 and a negative electrode 114.

The positive electrode 112 comprises a positive current collector 116 and positive active material 118.

The positive active material 118 comprises, more particularly is constituted of, lithium-based material(s), such as Lithium Metal Oxyde, LiNiMnCoO₂, LiFePO₄ or LiNiCoAlO₂.

The positive current collector 116, for example, comprises an aluminum Al foil.

The positive electrode 112 here further comprises a binder 120, for example a polymer, for example polyvinylidene fluoride (PVDF).

The positive electrode 112 here further comprises a conductive additive 122, for example carbon black and/or carbon nanotubes.

The negative electrode 114 comprises a negative current collector 124 and negative active material 126.

The negative current collector 124 comprises, for example, a copper Cu foil.

The negative active material 126 comprises at least one silicon-based material, for example silicon oxide (SiOx) and/or silicon carbide (SiC).

More particularly, the negative active material of each cell or the cell comprises at least 1,5 % mass of silicon.

Said silicon comprises, more particularly here consists of, the silicon comprised within the silicon-based material.

The silicon-based material comprises pure silicon nanodomains, said pure silicon nanodomains being bigger than 10 nm.

The negative active material 126, for example, further comprises graphite carbon.

The negative electrode 114 here further comprises a binder 128, for example a polymer, for example polyvinylidene fluoride (PVDF), and/or a combination of styrenebutadiene rubber (SBR) and carboxymethyl cellulose (CMC).

The positive electrode 112 and the negative electrode 114 are immersed together in an electrolyte 130, the electrolyte may be liquid or solid.

The liquid electrolyte comprises a solvent, for example an organic solvent, and lithium salt.

The solvent is, for example, ethylene carbonate (EC), dimethyl carbonate (DMC), ethyl methyl carbonate (EMC) or diethyl carbonate (DEC).

The lithium salt comprises for example Lithium hexafluorophosphate (LiPF6), Lithium bis(fluorosulfonyl)imide (LiFSI), and/or Lithium bis(trifluoromethanesulfonyl)imide (LiTFSI).

The positive electrode 112 and the negative electrode 114 are arranged apart from another, a separator 132 being arranged between the positive electrode 112 and the negative electrode 114.

The separator 132 for example comprises a base film, for example of polyolefin, in particular in Polypropylene (PP) or in Polyethylene (PE).

The separator, for example, comprises a coating, for example a ceramic coating, in particular comprising Aluminium oxide (Al₂O₃) or Aluminium hydroxide oxide (AlOOH).

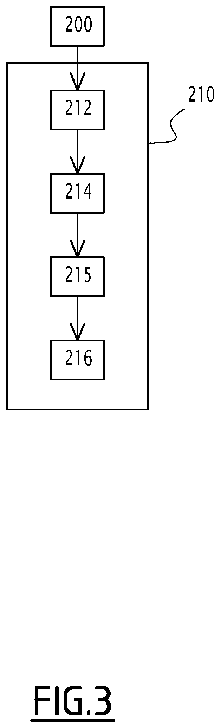

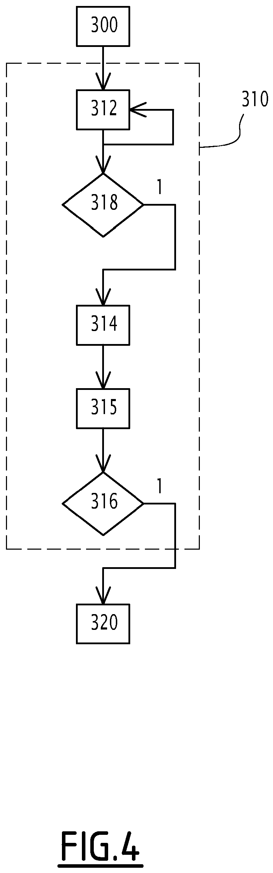

A method for monitoring a Li-ion battery pack comprising a plurality of battery cells, a Li-ion battery module comprising a plurality of battery cells, or a Li-ion battery cell, all as described previously, will now be described in view of figures 3 and 4.

As mentioned previously, the or each cell comprises negative active material, the negative active material comprising a silicon-based material.

More particularly, the negative active material of each cell or the cell comprises at least 1,5 % mass of silicon.

The silicon-based material comprises pure silicon nanodomains, said pure silicon nanodomains being bigger than 10 nm.

The method comprising the following phases:
- charging (200; 300) the battery pack or module or cell, and
- using (210; 310) the battery pack or module or cell, said using leading to a discharge of the battery pack or module or cell.

At the end of the charging step, here, the battery pack or module or cell has a state of charge superior or equal to 95%.

The method comprising the following steps:
- measuring (212; 312) the voltage of the or each cell and/or of the pack and/or of the module during the discharge,
- generating (214; 314) an electrochemical profile during the discharge,
- determining (215; 315) from the electrochemical profile the contribution of the silicon-based material to said electrochemical profile, and
- detecting (216; 316) an early indicator of imminent lithium plating based on said electrochemical profile.

The battery cells are here connected in series within the module, relative to a module, or within each module and within the pack, relative to a pack.

In the case of a module, the measuring step, for example, comprises measuring the voltage of each cell and of the module.

In the case of a pack, the measuring step, for example, comprises measuring the voltage of each cell and of the pack.

The or each voltage is measured during the whole phase of using, i.e during the whole discharge.

The or each voltage is measured according to an acquisition frequency.

The voltages are, for example, measured with the same acquisition frequency.

The acquisition frequency is, for example, comprised between 1 Hz and 10 Hz.

The measured voltages are sent to the battery management system 16, more particularly to a reception module 18.

The electrochemical profile is here generated for each or the cell.

The electrochemical profile represents the voltage of the battery pack, module or cell, here of the battery cell, depending on the capacity of the battery pack, module or cell, here of the battery cell.

The capacity of the battery back, module or cell is calculated from coulometric metering or from the measured current.

The electrochemical profile is calculated from the measured voltage(s), more particularly by a building profile module 20 of the battery management system 16, said building profile module 20 being connected to the reception module 18.

The reception module 18 sends the measured voltages to the building profile module 20.

The capacity considered here is, for example, the absolute capacity or the state of charge.

As represented on figure 4, in one embodiment, the electrochemical profile is updated every time a condition 318 is filled after a voltage(s) measurement, for example every k voltage(s) measurement, k being an integer between 1 and 100 or every predefined period.

Thus, said step is for example implemented at an analysis frequency, the acquisition frequency being between the analysis frequency and ten times the analysis frequency.

More particularly, the electrochemical profile is generated and gradually updated with the evolution of the voltage and the capacity.

Each update here corresponds to the addition of one point in the electrochemical profile.

Said point has an abscissa and an ordinate.

The abscissa corresponds to the capacity of the battery, and the ordinate to the voltage of the battery pack, module or cell, here cell.

The abscissa is, for example, the mean value of the capacity of the battery at the time of the previous measures since the last update.

The ordinate is, for example, the mean value of the voltage of the battery pack, module or cell, here cell, for the measures since the last update. In one embodiment, the measures considered for calculating the mean value exclude the outliers. Said outliers are, for example, identified using a known filter, for example based on the standard deviation error.

Alternatively, a plurality of points are added at each update. The ordinate of each point is the voltage of the battery pack, module or cell for each measure since the last update. The abscissa of each point is the capacity of the battery at the time of the corresponding measures. Outliers are, for example, identified and excluded from the profile.

The building profile module 20 is, for example, connected to a memory 22 of the battery management system 16.

The building profile module 20 sends the electrochemical profile to the memory 22.

The electrochemical profile is, for example, memorized in the memory 22 at the end of each generating step, such that, for the consecutive generating step, only the updated point(s) is (are) added to the profile, that is again memorized, and so on.

The electrochemical profile is gradually completed during the discharge phase.

Alternatively, only the updated point(s) is (are) considered for the determining and detecting step.

The determining (215; 315) is, for example, done after each generating step (214; 314).

The determining (215; 315) is implemented by a reconstruction module 23 of the battery management system 16, said reconstruction module 23 being connected to the building profile module 20.

The composition of each cell is known, as well as the individual electrochemical profile of each element composing the cell.

The building profile module 20 sends the electrochemical profile, complete with the historic or only the updated point(s), to the reconstruction module 23.

The contribution of the silicon-based material to the electrochemical profile of the battery pack, module or cell is deduced from the electrochemical profile, the composition of each cell and the respective individual electrochemical profiles, more particularly by reconstruction.

In particular, the contribution of each element composing the cell(s) to the electrochemical profile of the battery pack, module or cell is deduced from the electrochemical profile, the composition of each cell and the respective individual electrochemical profiles.

The contribution is here determined only for the updated point(s).

The contribution for the previous point(s) have already been calculated during anterior determining steps.

The reconstruction module 23 is, for example, connected to a memory 22 of the battery management system 16.

The reconstruction module 23, for example, sends the contribution of at least of the silicon-based material to the electrochemical profile to the memory 22.

The detecting (216; 316) is, for example, done after each determining step 215; 315.

The detecting is here implemented at the analysis frequency.

The detecting is implemented by a detection module 24 of the battery management system 16, said detection module 24 being connected to the reconstruction module 23.

The detection module 24 is also connected to the memory 22.

The reconstruction module 23 sends the contribution of the silicon-based material to electrochemical profile to the detection module 24.

The detecting comprises comparing said contribution, determined during the last determining step, to a predetermined or predefined profile.

The detecting is, for example, implemented for each cell independently. More particularly, the comparing is done between each contribution of the silicon-based material to the electrochemical profile generated for each cell and the predetermined or predefined profile.

The predetermined or predefined profile is, for example, the same for all the cells. Alternatively, different predetermined or predefined profiles are determined or defined for the cells.

The predetermined or predefined profile is previously recorded in the memory 22.

The predetermined or predefined profile can be, for example, updated by an update of the battery management system 16.

More particularly, the detecting comprises comparing the voltage of the contribution of the silicon-based material, in particular to the point or each point of the electrochemical profile added during the last generating step, to the value of voltage for the same capacity in the predetermined or predefined profile.

If the value of the contribution of the silicon-based material to the calculated electrochemical profile differs from the voltage value of the predetermined or predefined profile for the same capacity of at least a deviation value, an early indicator of imminent lithium plating is detected.

The deviation value is between 5 mV and 30 mV, more precisely between 15 mV and 25 mV.

Additionnally or alternatively, the detecting comprises detecting a plateau on the calculated contribution of the silicon-based material to the electrochemical profile.

A plateau is, for example, detected if the voltage of the contribution of the silicon-based material to the electrochemical profile varies only within 5 mV or less for an interval of capacity of a minimum given size, for example for at least 0,1% of the state of charge.

The generating, the determining and the detecting are done in parallel to the measuring step, during the discharge.

Thus, the detection of early indicator of imminent lithium plating is done directly during the discharge of the battery pack, module and/or cell.

This allows a prompt action or reaction in consequence.

If early indicator of imminent lithium plating is detected, an alert signal is sent, more particularly by the detection module 24, for example to a decision module 26.

In one embodiment, as depicted on figure 4, if the early indicator of imminent lithium plating is detected, the method further comprises at least one 320 of the following steps: displaying a visual alert, generating an audible alarm, reducing the accessible state of charge of the battery pack or module or cell, and reducing the maximum charging current of the battery pack or module or cell.

More particularly, if the early indicator of imminent lithium plating is detected, the method further comprises at least:
- displaying a visual alert and/or generating an audible alarm, and
- reducing the accessible state of charge of the battery pack or module or cell, and/or reducing the maximum charging current of the battery pack or module or cell.

The decision module 26 triggers said action(s), for example by sending control signals to the corresponding parts.

The decision module 26 is connected to the corresponding parts.

The visual alert is, for example, displayed on the control panel and/or central console of the vehicle.

The visual alert is, for example, an illuminated light and/or illuminated icon and/or a message on a display.

The audible alarm is, for example, a sound generated by a sound system of the vehicle.

Said alert and/or alarm, for example, prompts the user of the vehicle to go to a person of expertise, for example a dealership or garage.

The accessible state of charge of the battery is, for example, reduced to 70%.

The maximum charging current of the battery pack is, for example, reduced to 3,6 kW.

This allows operating the vehicle in a degraded mode, so that the user may bring the vehicle safely to the person of expertise.

In the example shown in Fig. 1, the battery management system is an electronic device comprising an information processing unit consisting, for example, of memory 22 and a processor associated with the memory.

When the detecting is done individually for each cell, this allows knowing which cell is not healthy and the concerned number of cells, so that the maintenance is done accordingly.

Each cell is, for example, identifiable using an identification reference.

The method then, for example, comprises displaying the identification reference(s) of the cell(s) where early indicator of imminent lithium plating has been detected, for example within a message on a display such as the control panel and/or central console.

Alternatively, said identification reference(s) are memorized within the memory 22, that is accessible to the person of expertise.

Alternatively, during the generating step, the electrochemical profile is generated only for each module, such that the detecting of the early indicator of imminent lithium plating is done for each module independently.

Alternatively, during the generating step, the electrochemical profile is generated only for the pack as a whole, such that the detecting of the early indicator of imminent lithium plating is done at the level of the pack.

In the example shown in Fig. 1, the reception module 18, the profile module 20, the reconstruction module 23, the detection module 24 and, optionally, the decision module 26 are each implemented in the form of software, or a software brick, executable by the processor. The battery management system's memory 22 can store reception software, profile software, detection software and, optionally, decision software. The processor is then able to execute each of the reception software, profile construction software and detection software, as well as the optional decision software.

In a variant not shown, the reception module 18, the profile module 20, the reconstruction module 23, the detection module 24 and, optionally, the decision module 26 are each implemented as a programmable logic component, such as an FPGA (Field Programmable Gate Array), or as an integrated circuit, such as an ASIC (Application Specific Integrated Circuit).

When the battery management system is implemented in the form of one or more software programs, i.e. in the form of a computer program, also known as a computer program product, it can also be recorded on a computer-readable medium (not shown). The computer-readable medium is, for example, a medium capable of storing electronic instructions and of being coupled to a bus of a computer system. By way of example, the readable medium is an optical disk, a magneto-optical disk, a ROM memory, a RAM memory, any type of non-volatile memory (e.g. FLASH or NVRAM) or a magnetic card. A computer program containing software instructions is stored on the readable medium.

The method of the invention allows early detection of the degradation of a cell, module or pack. Thus, quick actions are taken by the battery management system 16 at an early stage, before any wrong event happens.
10 battery pack
12 battery module
14, 110 battery cell
16 battery management system
18 reception module
20 profile module
22 memory
23 reconstruction module
24 detection module
26 decision module
112 positive electrode
114 negative electrode
116 positive current collector
118 positive active material
120 binder
122 conductive additive
124 negative current collector
126 negative active material
128 binder
130 electrolyte
132 separator
200, 300 charging phase
210, 310 using phase
212 ,312 measuring step
214, 314 generating step
216, 316 detecting step
318 condition
320 action step

## Claims

1. Method for monitoring a Li-ion battery pack (10) comprising a plurality of battery cells (14), a Li-ion battery module (12) comprising a plurality of battery cells (14), or a Li-ion battery cell (14), the or each cell (14) comprising negative active material (126), the negative active material comprising a silicon-based material, the method comprising the following phases:
- charging (200; 300) the battery pack or module or cell,
- using (210; 310) the battery pack or module or cell, said using leading to a discharge of the battery pack or module or cell,
the method comprising the following steps:
- measuring (212; 312) the voltage of the or each cell and/or of the pack and/or of the module during the discharge,
- generating (214; 314) an electrochemical profile during the discharge, the electrochemical profile representing the voltage depending on the capacity, said electrochemical profile being calculated from the measured voltage(s),
- determining (215; 315) from the electrochemical profile the contribution of the silicon-based material to said electrochemical profile, and
- detecting (216; 316) an early indicator of imminent lithium plating based on the contribution of the silicon-based material to said electrochemical profile.

2. Method according to claim 1, wherein the detecting (216; 316) comprises comparing the contribution of the silicon-based material to the electrochemical profile to a predetermined or predefined profile.

3. Method according to claim 2, wherein, if the value of the contribution of the silicon-based material to the calculated electrochemical profile differs from a voltage value of the predetermined or predefined profile for the same capacity of at least a deviation value, the early indicator of imminent lithium plating is detected.

4. Method according to claim 3, wherein the deviation value is between 5 mV and 30 mV, more precisely between 15 mV and 25 mV.

5. Method according to any one of claims 1 to 4, wherein, if the early indicator of imminent lithium plating is detected, the method further comprises at least one of the following steps (320): displaying a visual alert, generating an audible alarm, reducing the state of charge of the battery pack or module or cell, and reducing a charging current of the battery pack or module or cell.

6. Method according to any of claims 1 to 5, wherein the voltage(s) is measured according to an acquisition frequency, the generating, the determining and the detecting being implemented at an analysis frequency, the acquisition frequency being between the analysis frequency and ten times the analysis frequency.

7. Method according to any one of claims 1 to 6, wherein, at the end of the charging step (200; 300), the battery pack or module or cell has a state of charge superior or equal to 95%.

8. Method according to any one of claims 1 to 7, for monitoring a battery pack (10), wherein the battery cells (14) are connected in series, the voltage of each cell (14) and of the pack (10) being measured, the electrochemical profile of the silicon-based material being generated for each cell (14), such that the detecting (216; 316) of the early indicator of imminent lithium plating is done for each cell (14) independently.

9. Method according to any one of claims 1 to 8, wherein the negative active material (126) of each or the cell (14) comprises at least 1,5 % mass of silicon.

10. Method according to any one of claims 1 to 9, wherein the silicon-based material comprises pure silicon nanodomains, said pure silicon nanodomains being bigger than 10 nm.

11. Method according to any one of claims 1 to 10, wherein the measuring (212; 312), the determining (215; 315), the generating (214; 314) and the detecting (216; 316) steps are implemented by a battery management system (16).

12. Battery pack (10) comprising a plurality of battery cells (14) and a battery management system (16), each cell (14) comprising negative active material (126), the negative active material (126) comprising a silicon-based material, the battery management system (16) comprises, a reception module (18), a profile module (20) and a detection module (24), the reception module (18) being designed to receive a measured voltage of the or each cell (14) and/or of the module (12) and/or of the pack (10), the profile module (20) being adapted to generate an electrochemical profile of the silicon-based material during a discharge of the battery pack, the electrochemical profile representing the voltage linked to the silicon-based material depending on the capacity, said electrochemical profile being calculated from the measured voltage(s) received by the reception module (18), the detection module (24) being designed to receive the electrochemical profile from the profile module (20) and to detect an early indicator of imminent lithium plating based on said electrochemical profile.

## Patentansprüche

1. Verfahren zum Überwachen eines Li-Ionen-Batteriepacks (10), umfassend eine Vielzahl von Batteriezellen (14), eines Li-Ionen-Batteriemoduls (12), umfassend eine Vielzahl von Batteriezellen (14), oder einer Li-lonen-Batteriezelle (14), wobei die oder jede Zelle (14) umfassend negatives aktives Material (126), das negative aktive Material umfassend ein siliziumbasiertes Material, das Verfahren umfassend die folgenden Phasen:
- Laden (200; 300) des Batteriepacks oder -moduls oder -zelle,
- Verwenden (210; 310) des Batteriepacks oder -moduls oder -zelle, wobei das Verwenden zu einer Entladung des Batteriepacks oder -moduls oder -zelle führt, das Verfahren umfassend die folgenden Schritte:
- Messen (212; 312) der Spannung der oder jeder Zelle und/oder des Packs und/oder des Moduls während der Entladung,
- Erzeugen (214; 314) eines elektrochemischen Profils während der Entladung, wobei das elektrochemische Profil die von der Kapazität abhängige Spannung darstellt, wobei das elektrochemische Profil anhand der gemessenen Spannung(en) berechnet wird,
- Bestimmen (215; 315), anhand des elektrochemischen Profils, des Beitrags des siliziumbasierten Materials zu dem elektrochemischen Profil, und
- Erkennen (216; 316) eines frühen Indikators für ein bevorstehendes Lithium-Plating basierend auf dem Beitrag des siliziumbasierten Materials zu dem elektrochemischen Profil.

2. Verfahren nach Anspruch 1, wobei das Erfassen (216; 316) ein Vergleichen des Beitrags des siliziumbasierten Materials zu dem elektrochemischen Profil mit einem vorbestimmten oder vordefinierten Profil umfasst.

3. Verfahren nach Anspruch 2, wobei, wenn der Wert des Beitrags des siliziumbasierten Materials zu dem berechneten elektrochemischen Profil von einem Spannungswert des vorbestimmten oder vordefinierten Profils für dieselbe Kapazität um mindestens einen Abweichungswert abweicht, der frühe Indikator für bevorstehendes Lithium-Plating erkannt wird.

4. Verfahren nach Anspruch 3, wobei der Abweichungswert zwischen 5 mV und 30 mV, genauer gesagt zwischen 15 mV und 25 mV ist.

5. Verfahren nach einem der Ansprüche 1 bis 4, wobei das Verfahren, wenn der frühe Indikator eines bevorstehenden Lithium-Platings erkannt wird, ferner mindestens einen der folgenden Schritte (320) umfasst: Anzeigen eines visuellen Alarms, Erzeugen eines akustischen Alarms, Reduzieren des Ladezustands des Batteriepacks oder -moduls oder -zelle und Reduzieren eines Ladestroms des Batteriepacks oder -moduls oder - zelle.

6. Verfahren nach einem der Ansprüche 1 bis 5, wobei die Spannung(en) gemäß einer Erfassungsfrequenz gemessen wird (werden), wobei das Erzeugen, das Bestimmen und das Erfassen mit einer Analysefrequenz durchgeführt werden, wobei die Erfassungsfrequenz zwischen der Analysefrequenz und dem Zehnfachen der Analysefrequenz ist.

7. Verfahren nach einem der Ansprüche 1 bis 6, wobei am Ende des Ladeschritts (200; 300) der Batteriesatz oder -Modul oder -zelle einen Ladezustand von mehr als oder gleich wie 95 % aufweist.

8. Verfahren nach einem der Ansprüche 1 bis 7 zum Überwachen eines Batteriepacks (10), wobei die Batteriezellen (14) in Reihe verbunden sind, die Spannung jeder Zelle (14) und des Packs (10) gemessen wird, das elektrochemische Profil des siliziumbasierten Materials für jede Zelle (14) erzeugt wird, sodass die Erfassung (216; 316) des frühen Indikators von bevorstehendem Lithium-Plating für jede Zelle (14) unabhängig erfolgt.

9. Verfahren nach einem der Ansprüche 1 bis 8, wobei das negative aktive Material (126) jeder Zelle (14) mindestens 1,5 Masseprozent Silizium umfasst.

10. Verfahren nach einem der Ansprüche 1 bis 9, wobei das siliziumbasierte Material reine Silizium-Nanodomänen umfasst, wobei die reinen Silizium-Nanodomänen größer sind als 10 nm.

11. Verfahren nach einem der Ansprüche 1 bis 10, wobei die Schritte des Messens (212; 312), des Bestimmens (215; 315), des Erzeugens (214; 314) und des Erfassens (216; 316) von einem Batteriemanagementsystem (16) implementiert werden.

12. Batteriepack (10), umfassend eine Vielzahl von Batteriezellen (14) und ein Batteriemanagementsystem (16), jede Zelle (14) umfassend negatives aktives Material (126), das negative aktive Material (126) umfassend ein siliziumbasiertes Material, wobei das Batteriemanagementsystem (16) ein Empfangsmodul (18), ein Profilmodul (20) und ein Erfassungsmodul (24) umfasst, wobei das Empfangsmodul (18) konstruiert ist, um eine gemessene Spannung der oder jeder Zelle (14) und/oder des Moduls (12) und/oder des Packs (10) zu empfangen, das Profilmodul (20) angepasst ist, um ein elektrochemisches Profil des siliziumbasierten Materials während einer Entladung des Batteriepacks zu erzeugen, das elektrochemische Profil, das die Spannung, die mit dem siliziumbasierten Material verbunde ist, abhängig von der Kapazität darstellt, wobei das elektrochemische Profil anhand der gemessenen Spannung(en) berechnet wird, die von dem Empfangsmodul (18) empfangen wird/werden, wobei das Erfassungsmodul (24) konstruiert ist, um das elektrochemische Profil von dem Profilmodul (20) zu empfangen und basierend auf dem elektrochemischen Profil einen frühen Indikator für ein bevorstehendes Lithium-Plating zu erfassen.

## Revendications

1. Procédé de surveillance d'un bloc-batterie Li-ion (10) comprenant une pluralité d'éléments de batterie (14), un module de batterie Li-ion (12) comprenant une pluralité d'éléments de batterie (14), ou un élément de batterie Li-ion (14), l'élément ou chaque élément (14) comprenant un matériau actif négatif (126), le matériau actif négatif comprenant un matériau à base de silicium, le procédé comprenant les phases suivantes :
- charge (200 ; 300) du bloc, du module ou de l'élément de batterie,
- utilisation (210 ; 310) du bloc, du module ou de l'élément de batterie, ladite utilisation entraînant une décharge du bloc, du module ou de l'élément de batterie, le procédé comprenant les étapes suivantes :
- mesure (212 ; 312) de la tension du ou de chaque élément et/ou du bloc et/ou du module pendant la décharge,
- génération (214 ; 314) d'un profil électrochimique pendant la décharge, le profil électrochimique représentant la tension en fonction de la capacité, ledit profil électrochimique étant calculé à partir de la ou des tensions mesurées,
- détermination (215 ; 315) à partir du profil électrochimique de la contribution du matériau à base de silicium audit profil électrochimique, et
- détection (216 ; 316) d'un indicateur précoce de l'imminence d'un placage au lithium sur la base de la contribution du matériau à base de silicium audit profil électrochimique.

2. Procédé selon la revendication 1, dans lequel la détection (216 ; 316) comprend la comparaison de la contribution du matériau à base de silicium au profil électrochimique à un profil prédéterminé ou prédéfini.

3. Procédé selon la revendication 2, dans lequel, si la valeur de la contribution du matériau à base de silicium au profil électrochimique calculé diffère d'une valeur de tension du profil prédéterminé ou prédéfini pour la même capacité d'au moins une valeur d'écart, l'indicateur précoce d'un placage au lithium imminent est détecté.

4. Procédé selon la revendication 3, dans lequel la valeur d'écart est comprise entre 5 mV et 30 mV, plus précisément entre 15 mV et 25 mV.

5. Procédé selon l'une quelconque des revendications 1 à 4, dans lequel, si l'indicateur précoce d'un placage au lithium imminent est détecté, le procédé comprend en outre au moins l'une des étapes suivantes (320) : affichage d'une alerte visuelle, génération d'une alarme sonore, réduction de l'état de charge du bloc, du module ou de l'élément de batterie, et réduction d'un courant de charge du bloc, du module ou de l'élément de batterie.

6. Procédé selon l'une quelconque des revendications 1 à 5, dans lequel la ou les tensions sont mesurées selon une fréquence d'acquisition, la génération, la détermination et la détection étant mises en œuvre à une fréquence d'analyse, la fréquence d'acquisition étant comprise entre la fréquence d'analyse et dix fois la fréquence d'analyse.

7. Procédé selon l'une quelconque des revendications 1 à 6, dans lequel, à la fin de l'étape de charge (200 ; 300), le bloc, module ou élément de batterie a un état de charge supérieur ou égal à 95 %.

8. Procédé selon l'une quelconque des revendications 1 à 7, pour surveiller un bloc-batterie (10), dans lequel les éléments de batterie (14) sont connectés en série, la tension de chaque élément (14) et du bloc (10) étant mesurée, le profil électrochimique du matériau à base de silicium étant généré pour chaque élément (14), de sorte que la détection (216 ; 316) de l'indicateur précoce d'un placage au lithium imminent est effectuée pour chaque élément (14) indépendamment.

9. Procédé selon l'une quelconque des revendications 1 à 8, dans lequel le matériau actif négatif (126) de l'élément ou de chaque élément (14) comprend au moins 1,5 % en masse de silicium.

10. Procédé selon l'une quelconque des revendications 1 à 9, dans lequel le matériau à base de silicium comprend des nanodomaines de silicium pur, lesdits nanodomaines de silicium pur ayant une taille supérieure à 10 nm.

11. Procédé selon l'une quelconque des revendications 1 à 10, dans lequel les étapes de mesure (212 ; 312), de détermination (215 ; 315), de génération (214 ; 314) et de détection (216 ; 316) sont mises en œuvre par un système de gestion de batterie (16).

12. Bloc-batterie (10) comprenant une pluralité d'éléments de batterie (14) et un système de gestion de batterie (16), chaque élément (14) comprenant un matériau actif négatif (126), le matériau actif négatif (126) comprenant un matériau à base de silicium, le système de gestion de batterie (16) comprend, un module de réception (18), un module de profil (20) et un module de détection (24), le module de réception (18) étant conçu pour recevoir une tension mesurée de l'élément ou de chaque élément (14) et/ou du module (12) et/ou du bloc (10), le module de profil (20) étant adapté pour générer un profil électrochimique du matériau à base de silicium pendant une décharge du bloc-batterie, le profil électrochimique représentant la tension liée au matériau à base de silicium en fonction de la capacité, ledit profil électrochimique étant calculé à partir de la ou des tensions mesurées reçues par le module de réception (18), le module de détection (24) étant conçu pour recevoir le profil électrochimique du module de profil (20) et pour détecter un indicateur précoce d'un placage au lithium imminent sur la base dudit profil électrochimique.
